# EUROPEAN PATENT SPECIFICATION

(11) **EP 3 151 286 B1**
(45) Date of publication and mention of the grant of the patent: **08.12.2021**
(21) Application number: 15799245.4
(22) Date of filing: 22.05.2015
(51) Int. Cl.: H01L 31/0216, H01L 31/068, H01L 31/18, C23C 16/40, C23C 16/455, H01L 21/02

(54) **SOLAR CELL ELEMENT, METHOD FOR MANUFACTURING SAME AND SOLAR CELL MODULE**
SOLARZELLENELEMENT, VERFAHREN ZUR HERSTELLUNG DAVON UND SOLARZELLENMODUL
ÉLÉMENT DE CELLULE SOLAIRE, PROCÉDÉ DE FABRICATION DE CELUI-CI ET MODULE DE CELLULE SOLAIRE

(30) Priority: 29.05.2014 JP 2014111370; 27.06.2014 JP 2014132434
(43) Date of publication of application: 05.04.2017
(73) Proprietor: Kyocera Corporation, Kyoto-shi, Kyoto 612-8501 (JP)
(72) Inventor: ITO, Norikazu, Kyoto-shi Kyoto 612-8501 (JP); MURAO, Akira, Kyoto-shi Kyoto 612-8501 (JP); KUSUHARA, Kenji, Kyoto-shi Kyoto 612-8501 (JP)
(74) Representative: SSM Sandmair
(86) International application number: PCT/JP2015/064717
(87) International publication number: WO 2015/182503

(56) References cited:
- WO-A1-2011/033826
- WO-A1-2014/030765
- WO-A1-2014/030765
- WO-A1-2014/030765
- WO-A1-2015/006247
- JP-A- 2008 533 731
- JP-A- 2012 253 356
- US-A1- 2013 330 936
- US-A1- 2013 330 936

## Description

### Technical Field

The present invention relates to a solar cell element and a solar cell module.

### Background Art

A general solar cell element includes a semiconductor substrate composed of silicon as a photoelectric conversion material. A passivation layer is provided on a surface of a semiconductor substrate for reducing a minority carrier recombination loss which causes a reduction in photoelectric conversion efficiency of a solar cell element. As a material of the passivation layer, for example, an oxide such as silicon oxide or aluminum oxide, or a nitride such as a silicon nitride film is used. When among the above-mentioned materials, aluminum oxide formed by, for example, an atomic layer deposition (ALD) method is used, a minority carrier recombination loss can be reduced to achieve satisfactory characteristics (see, for example, Japanese Patent Application Laid-Open No. 2004-193350, Japanese Patent Application Laid-Open No. 2009-164544 and National Publication of International Patent Application No. 2012-530361).

However, aluminum oxide is easily degenerated by penetration of moisture. Thus, it has been proposed that a protective layer is formed on a passivation layer by a plasma-enhanced CVD (PECVD) method etc. (see, for example, Japanese Patent Application Laid-Open No. 2012-253356 and International Publication No. WO 2011/033826).
US 2013 330936 A1 concerns a method of deposition of Al₂O₃/SiO₂ and Si₃N₄/Al₂O₃/SiO₂ stacks, from aluminium and silicon precursors, useful for the deposition of thin films in photovoltaic technologies, in particular for solar cells.
WO 2014/030765 A1 discloses a solar cell element that includes a semiconductor substrate having a first main surface and a second main surface located on the opposite side of the first main surface.
WO 2015/006247 A1 provides stable surface passivation on a crystalline silicon substrate by forming a more heavily doped region as a front surface field and/or a doped dielectric layer under a passivation layer on the silicon substrate surface.

### Summary of Invention

### Problems to be Solved by the Invention

However, in formation of a protective layer, a passivation layer may be degraded under the influence of heat and plasma. In this case, the function of the passivation layer is deteriorated, so that the photoelectric conversion efficiency of a solar cell element and a solar cell module is reduced from the initial stage.

An object of the present invention is to provide a solar cell element and a solar cell module which are capable of maintaining high photoelectric conversion efficiency.

### Means for Solving the Problems

A solar cell element according to one aspect of the present invention is defined by the subject-matter of independent claim 1. Dependent claims 2-7 are directed to advantageous embodiments of the solar cell element.

A solar cell module including the solar cell element according to one aspect of the present invention is defined in dependent claim 8.
The embodiments and/or examples of the following description which are not covered by the claims, are provided for illustrative purpose only and are only intended to assist the reader in understanding the present invention. However, such embodiments and/or examples which are not covered by the claims do not form part of the present invention that is solely defined by the claims.

### Effects of the Invention

According to a solar cell element, a method for manufacturing the solar cell element, and a solar cell module as described above, there can be provided a solar cell element and a solar cell module which are capable of maintaining high photoelectric conversion efficiency.

### Brief Description of Drawings

Fig. 1 is a plan view showing an external appearance, on a first main surface side, of a solar cell element according to one example.
Fig. 2 is a plan view showing an external appearance, on a second main surface side, of a solar cell element according to example.
Fig. 3 is a sectional view showing a cross section taken along line A-A in Fig. 1 and Fig. 2.
Fig. 4(a) is an enlarged sectional view schematically showing a passivation layer and a protective layer on the first main surface of the solar cell element according to one example;
and Fig. 4(b) is an enlarged sectional view schematically showing a passivation layer and a protective layer on the second main surface of the solar cell element according to one example.
Fig. 5(a) is an enlarged sectional view schematically showing a passivation layer and a protective layer on a first main surface of a solar cell element according to another example;
and Fig. 5(b) is an enlarged sectional view schematically showing a passivation layer and a protective layer on a second main surface of the solar cell element according to the present invention
Fig. 6 is a plan view showing an external appearance, on a second main surface side, of a solar cell element according to a modification of the present invention.
Fig. 7 is a sectional view showing a cross section taken along line B-B in Fig. 6.
Fig. 8 is a plan view showing an external appearance of a solar cell module according to one embodiment of the present invention.
Fig. 9 is a sectional view showing a cross section of the solar cell module according to one embodiment of the present invention.

### Description of Embodiments

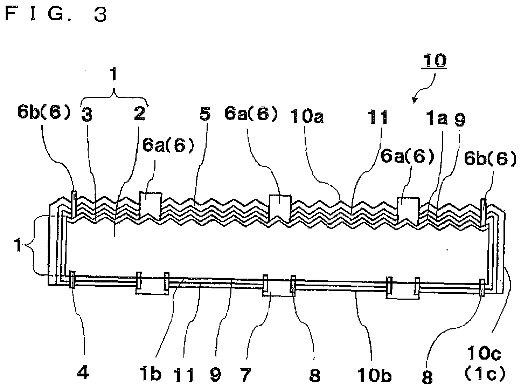

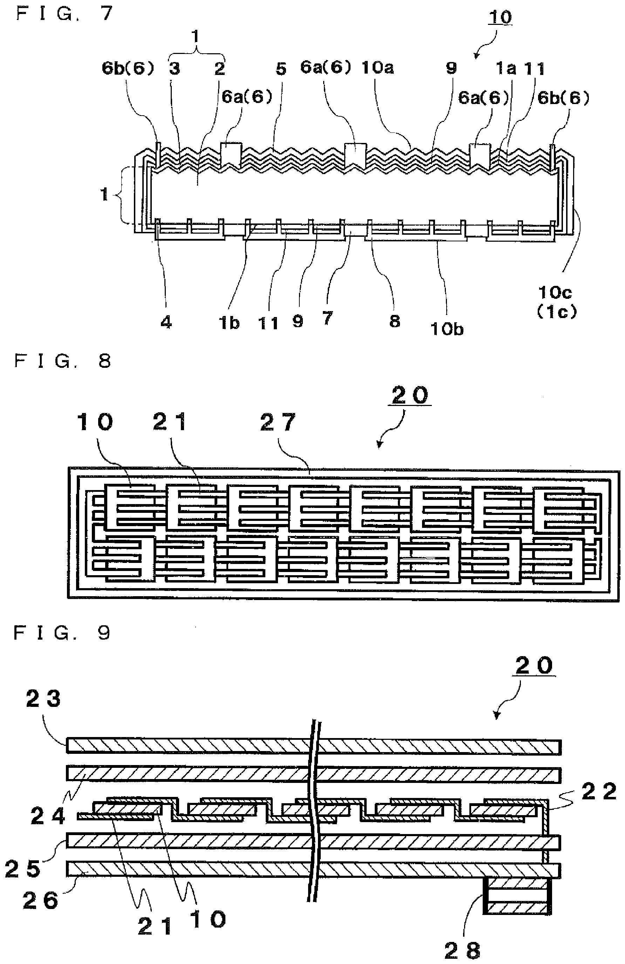

Hereinafter, embodiments of a solar cell element, a method for manufacturing the solar cell element, and a solar cell module according to the present invention will be described with reference to the drawings. The drawings are schematically shown. In Fig. 3 and Fig. 7, hatchings that show the cross sections of components are omitted for making it easy to see the components.

### <<First Example>>

### <Solar cell element>

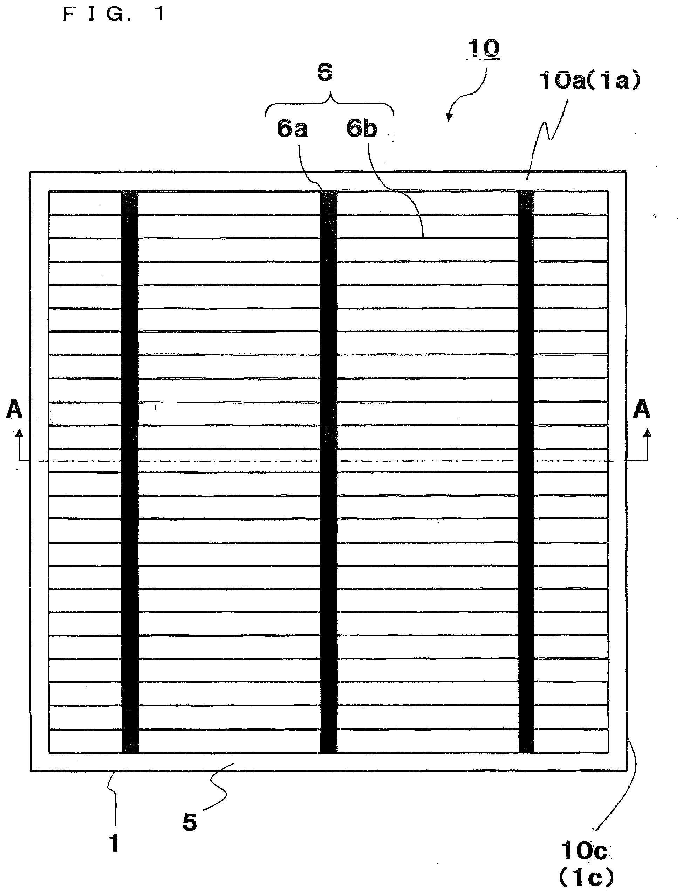

A solar cell element 10 according to this example is shown in Figs. 1 to 4.

As shown in Fig. 3, the solar cell element 10 has a first main surface 10a as a light-receiving surface to which light is mainly incident; a second main surface 10b as one main surface (back surface) situated on a side opposite to the first main surface 10a; and a side surface 10c. The solar cell element 10 includes a silicon substrate 1 as a semiconductor substrate. The silicon substrate 1 has a first main surface 1a; a second main surface 1b situated on a side opposite to the first main surface 1a; and a side surface 1c. The silicon substrate 1 includes a first semiconductor layer 2 as a one-conductivity-type (e.g. p-type) semiconductor region; and a second semiconductor layer 3 as an opposite-conductivity-type (e.g. n-type) semiconductor region provided on the first main surface 1a side of the first semiconductor layer 2. Further, the solar cell element 10 includes a third semiconductor layer 4, an antireflection layer 5, a first electrode 6, a second electrode 7, a third electrode 8, a passivation layer 9 and a protective layer 11.

The silicon substrate 1 is, for example, a single-crystalline silicon substrate or a polycrystalline silicon substrate. The silicon substrate 1 includes the first semiconductor layer 2; and the second semiconductor layer 3 provided on the first main surface 1a side of the first semiconductor layer 2. For the semiconductor substrate, a material other than silicon may be used as long as the semiconductor substrate includes the above-mentioned first semiconductor layer 2 and second semiconductor layer 3.

Hereinafter, an example will be described in which a p-type semiconductor is used as the first semiconductor layer 2. When a p-type semiconductor is used for the first semiconductor layer 2, a p-type silicon substrate is used as the silicon substrate 1. As the silicon substrate 1, a polycrystalline or single-crystalline substrate is used, and for example, a thin substrate having a thickness of 250 µm or less, or even 150 µm or less can be used. The shape of the silicon substrate 1 is not particularly limited, but a substantially tetragonal shape in plan view is suitable because a gap between elements can be reduced in manufacturing of a solar cell module 20 from the solar cell elements 10. For ensuring that the conductivity type of the first semiconductor layer 2 comprised of the polycrystalline silicon substrate 1 is a p-type, an impurity such as boron or gallium is contained as a dopant element.

The second semiconductor layer 3 is laminated on the first semiconductor layer 2. The second semiconductor layer 3 has a conductivity type (n-type in this example) opposite to that of the first semiconductor layer 2, and is provided on the first main surface 1a side of the first semiconductor layer 2. Accordingly, the silicon substrate 1 includes a pn junction part at the interface between the first semiconductor layer 2 and the second semiconductor layer 3. The second semiconductor layer 3 can be formed by, for example, diffusing an impurity such as phosphorus as a dopant to the first main surface 1a side of the silicon substrate 1.

As shown in Fig. 3, fine irregularity structures (textures) for reducing the reflectivity to applied light may be provided on the first main surface 1a side of the silicon substrate 1. The height of the projected portion in the texture is about 0.1 to 10 µm, and the distance between adjacent projected portions is about 0.1 to 20 µm. In the texture, for example, the recessed portion may have a substantially spherical shape, and/or the projected portion may have a pyramidal shape. The "height of the projected portion" is a distance between a reference line and the top face of the projected portion in a direction vertical to the reference line where the reference line is a straight line passing through the bottom face of the recessed portion in, for example, Fig. 3. The "distance between projected portions" is a distance between the centers of the top faces of mutually adjacent projected portions in a direction parallel to the reference line.

The antireflection layer 5 has a function of reducing the reflectivity to light applied to the first main surface 10a of the solar cell element 10. The antireflection layer 5 includes, for example, a silicon oxide layer, an aluminum oxide layer or a silicon nitride layer. As the refractive index and the thickness of the antireflection layer 5, a reflective index and a thickness may be appropriately employed which ensure that low reflection conditions can be achieved for light which is sunlight with such a wavelength range that the light can be absorbed in the silicon substrate 1 to contribute to power generation. For example, the antireflection layer 5 may have a refractive index of about 1.8 to 2.5 and a thickness of about 20 to 120 nm.

The third semiconductor layer 4 may be located on the second main surface 1b side of the silicon substrate 1, and have a conductivity type (p-type in this example) identical to that of the first semiconductor layer 2. The concentration of a dopant contained in the third semiconductor layer 4 is higher than the concentration of a dopant contained in the first semiconductor layer 2. That is, in the third semiconductor layer 4, a dopant element exists in a concentration higher than the concentration of a dopant element contained in the first semiconductor layer 2 for ensuring that the first semiconductor layer 2 has a one-conductivity type. The third semiconductor layer 4 forms an internal electric field on the second main surface 1b side of the silicon substrate 1. Accordingly, a reduction in photoelectric conversion efficiency due to recombination of minority carriers hardly occurs in the vicinity of the second main surface 1b of the silicon substrate 1. The third semiconductor layer 4 can be formed by, for example, diffusing a dopant element such as boron or aluminum to the second main surface 1b side of the silicon substrate 1. The concentrations of dopant elements contained in the first semiconductor layer 2 and the third semiconductor layer 4 may be about 5 × 10¹⁵ to 1 × 10¹⁷ atoms/cm³ and 1 × 10¹⁸ to 5 × 10²¹ atoms/cm³, respectively. The third semiconductor layer 4 may exist at a contact part between the second electrode 7 as described later and the silicon substrate 1.

The first electrode 6 is an electrode provided on the first main surface 1a side of the silicon substrate 1. The first electrode 6 includes a power extraction electrode 6a and a plurality of linear collecting electrodes 6b as shown in Fig. 1. The power extraction electrode 6a is an electrode for extracting electricity obtained by power generation, and its length in a short direction (hereinafter, referred to a width) is, for example, about 1.3 to 2.5 mm. At least a part of the power extraction electrode 6a intersects the collecting electrodes 6b and is electrically connected to the collecting electrodes 6b. The collecting electrode 6b is an electrode for collecting electricity generated from the silicon substrate 1. The collecting electrodes 6b are in the form of a plurality of lines, and each have a width of, for example, about 50 to 200 µm. Thus, the width of the collecting electrode 6b is smaller than the width of the power extraction electrode 6a. A plurality of collecting electrodes 6b are provided at mutual intervals of about 1 to 3 mm. The thickness of the first electrode 6 is about 10 to 40 µm. For example, the first electrode 6 can be formed in the following manner: a first metal paste containing silver as a main component is applied in a desired shape by screen printing etc., and then fired. In this example, the main component means that the content is 50% or more based on the amount of all components.

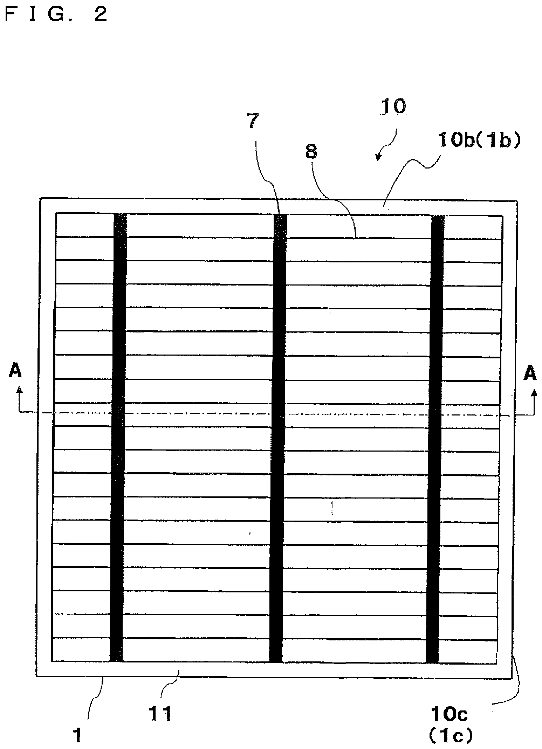

The second electrode 7 and the third electrode 8 are electrodes provided on the second main surface 1b side of the silicon substrate 1 as shown in Fig. 2 and Fig. 3. The second electrode 7 is an electrode for extracting electricity obtained by power generation by the solar cell element 10. The second electrode 7 has a thickness of about 10 to 30 µm, and a width of about 1.3 to 7 mm.

The second electrode 7 contains silver as a main component. For example, the second electrode 7 can be formed in the following manner: a metal paste containing silver as a main component is applied in a desired shape by screen printing etc., and then fired.

The third electrode 8 is an electrode for collecting electricity generated at the silicon substrate 1 on the second main surface 1b of the silicon substrate 1, and is provided so as to be electrically connected to the second electrode 7 as shown in Fig. 2 and Fig. 3. At least a part of the second electrode 7 may be connected to the third electrode 8. The third electrode 8 not only intersects the second electrode 7 as shown in Fig. 2, but also is located parallel to the long direction of the second electrode 7, and connected to the second electrode 7 as shown in Fig. 3. The thickness of the third electrode 8 is about 15 to 50 µm. For example, the third electrode 8 may be in the form of a plurality of lines as with the collecting electrodes 6b. The third electrode 8 has a width of, for example, about 100 to 500 µm, and a plurality of third electrodes 8 are provided at mutual intervals of about 1 to 3 mm. By increasing the width of the third electrode 8 as compared to the width of the collecting electrode 6b of the first electrode 6, the series resistance of the third electrode 8 can be decreased to improve the power characteristics of the solar cell element 10.

The third electrode 8 contains aluminum as a main component. For example, the third electrode 8 can be formed in the following manner: a metal paste containing aluminum as a main component is applied in a desired shape, and then fired.

The passivation layer 9 is formed on at least the second main surface 1b of the silicon substrate 1, and has a function of reducing recombination of minority carriers. For example, aluminum oxide formed by an ALD method is employed as the passivation layer 9. The thickness of the passivation layer 9 is about 10 to 200 nm.

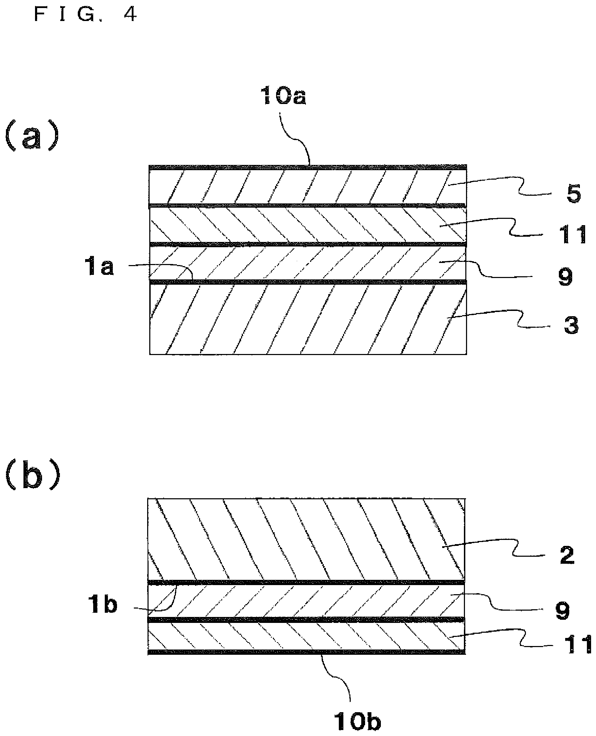

The protective layer 11 is located on the passivation layer 9 (for example, under the illustrated passivation layer 9 in Fig. 4(b)) located on the first semiconductor layer 2 (for example, under the illustrated first semiconductor layer 2 in Fig. 4(b)) and containing aluminum oxide. Thus, the passivation layer 9 is located on at least the first semiconductor layer 2 that is a p-type semiconductor region. As shown in, for example, Fig. 4(a), the passivation layer 9 may be located on the second semiconductor region 3 of the n-type semiconductor region, with the protective layer 11 further located thereon.

The protective layer 11 is located on the passivation layer 9 for protecting the passivation layer 9 to obtain the solar cell element 10 excellent in reliability in moisture resistance, etc. The protective layer 11 may be a layer containing silicon oxide which contains hydrogen and carbon. For example, the protective layer 11 may also have a laminated structure of a silicon oxide layer containing hydrogen and carbon and other one or more metal oxide layers (zirconium oxide layer, hafnium oxide layer and so on). The metal oxide layer is easily prepared by an ALD method as with the silicon oxide layer. When a layer having a passivation effect, such as a zirconium oxide layer or a hafnium oxide layer, is used as the metal oxide layer, improvement of photoelectric conversion efficiency can be improved, and the protecting function of the protective layer 11 can be further improved. Accordingly, the solar cell element 10 having satisfactory initial photoelectric conversion efficiency and high reliability can be prepared.

The protective layer 11 is formed by, for example, an ALD method. When a silicon oxide layer is used as the protective layer 11, and an aluminum oxide layer is used as the passivation layer 9, the thickness of the protective layer 11 is preferably smaller than that of the passivation layer 9 in view of a fixed charge, etc. Particularly when the protective layer 11 containing silicon oxide is formed, the thickness of the passivation layer 9 comprised of aluminum oxide may be two or more times as large as that of the protective layer 11. Accordingly, the passivation effect of the passivation layer 9 is not reduced, and thus reliability can be improved. Particularly, when the thickness of the protective layer 11 is about 5 to 15 nm, the solar cell element 10 excellent in initial characteristics and reliability in photoelectric conversion efficiency can be obtained.

The content of hydrogen in the protective layer 11 may be in the range of 1 to 10 atom%. Accordingly, the passivation effect of the passivation layer 9 can be improved, and further, initial characteristics can be maintained over a long period of time.

When the content of carbon in the protective layer 11 is in the range of 1 to 10 atom%, the moisture permeability is reduced due to the presence of carbon. Accordingly, initial photoelectric conversion efficiency can be increased while the protective layer 11 is kept thin, so that initial characteristics can be maintained over a long period of time. The contents of hydrogen and carbon in the protective layer 11 can be measured by, for example, SIMS (secondary ion mass spectrometry).

Initial photoelectric conversion efficiency of the solar cell element 10 can be improved by a negative fixed charge from carbon. Since the protective layer 11 contains hydrogen, hydrogen can be supplied to the interface between the silicon substrate 1 and the passivation layer 9. Accordingly, dangling bonds of silicon atoms are terminated with hydrogen, and therefore the initial photoelectric conversion efficiency of the solar cell element 10 can be improved.

The protective layer 11 may further contain nitrogen. When the protective layer 11 contains nitrogen, the protective layer 11 may be densified to reduce the permeability rate of moisture in the air. Accordingly, the amount of moisture arriving at the passivation layer 9 can be reduced. Further, a reduction in photoelectric conversion efficiency due to degeneration of the passivation layer 9 can be made hard to occur.

Both the passivation layer 9 and the protective layer 11 can be formed by an ALD method. After the passivation layer 9 comprised of aluminum oxide is formed by an ALD method, the protective layer 11 comprised of silicon oxide can be formed in the same chamber without taking out the silicon substrate 1 into the air. Accordingly, a reduction in passivation effect due to formation of defects and ingress of impurities is hard to occur at the interface between the passivation layer 9 and the protective layer 11. Formation of the passivation layer 9 and the protective layer 11 by an ALD method is good because productivity is improved.

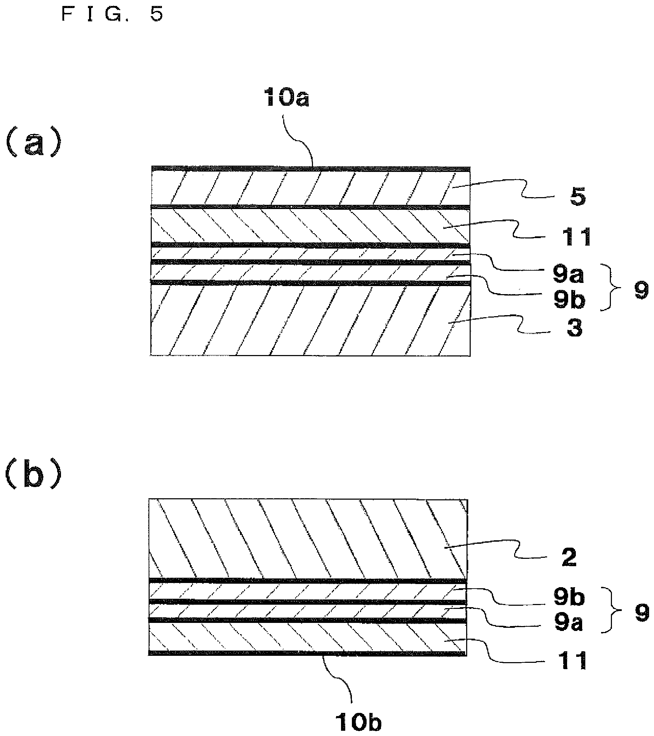

Here, on a first passivation layer 9a, at least one of the antireflection layer 5 and the other passivation layer may be formed by, for example, a PECVD method to obtain a film having a positive fixed charge, such as that of silicon nitride, as shown in Fig.5(a). By disposing such a film on an n-type layer (second semiconductor layer 3 in this embodiment) of the silicon substrate 1, recombination of minority carriers can be reduced by an electric field effect at the interface between the second semiconductor layer 3 and the passivation layer 9. Similarly, when as the antireflection layer 5 and the passivation layer 9, a film having a negative fixed charge, such as an aluminum oxide layer, is formed on a p-type layer (first semiconductor layer 2 in this example) of the silicon substrate 1, recombination of minority carriers at the interface can be reduced by an electric field effect of the film.

When an ALD method etc. is used, the protective film 11 can be formed without subjecting the passivation layer 9 to plasma exposure. Accordingly, during formation of the protective layer 11 and the antireflection layer 5, the passivation layer 9 does not suffer plasma damage (etching damage to the aluminum oxide film, generation of defects, and ingress of impurities in the aluminum oxide film due to collision of electrons generated by plasma).

As shown in Fig. 5(b), according to the present invention a second passivation layer 9b containing silicon oxide is formed between the p-type semiconductor region (first semiconductor layer 2 in this embodiment) and the first passivation layer 9a is formed including an aluminum oxide layer. Accordingly, passivation performance can be improved. The second passivation layer 9b is a layer for reducing defects at the interface between the silicon substrate 1 and the first passivation layer 9a. The thickness of the second passivation layer 9b is smaller than the thickness of the first passivation layer 9a. Particularly, the second passivation layer 9b may be a silicon oxide layer having a thickness of 0.1 to 1 nm, and a hydrogen content of 1 to 10 atom%, more preferably 3 to 10 atom%. The second passivation layer 9b exists between the first passivation layer 9a and the silicon substrate 1 similar in material to silicon oxide that forms the second passivation layer 9b. Thus, it is considered that the second passivation layer 9b is located as a buffer layer between the silicon substrate 1 and the first passivation layer 9a to reduce generation of defects in the passivation layer 9. Accordingly, recombination of minority carriers at the interface between the silicon substrate 1 and the passivation layer 9 can be reduced. The thickness of the second passivation layer 9b comprised of silicon oxide may be in the above-mentioned range because a surface of the silicon substrate 1 is easily covered. When the thickness of the second passivation layer 9b is in the above-mentioned range, the passivation effect by the negative fixed charge of the first passivation layer 9a is not reduced even under the influence of the positive fixed charge of the second passivation layer 9b. The thickness of the second passivation layer 9b is smaller than the thickness of the protective layer 11. Further, the total thickness of the second passivation layer 9b and the protective layer 11 is smaller than the thickness of the first passivation layer 9a. When the thickness of the second passivation layer 9b is in the above-mentioned range, passivation performance by the negative fixed charge of the first passivation layer 9a is easily sufficiently exhibited.

When the hydrogen content of the second passivation layer 9b is in the range of 1 to 10 atom%, more preferably 3 to 10 atom%, crystal defects such as dangling bonds and crystal grain boundaries in the vicinity of the surfaces of the silicon substrate 1 can be terminated with hydrogen, and thereby inactivated. The method for forming the second passivation layer 9b may be, for example, an ALD method. Accordingly, the second passivation layer 9b can be thinly and uniformly formed easily and conveniently.

The passivation layer 9 may be located on at least the second main surface 1b that is one main surface of the silicon substrate 1, but the passivation layer 9 may also be located on both main surface sides of the silicon substrate 1. Accordingly, passivation performance may be improved. When the antireflection layer 5 and the passivation layer 9 are also formed on the side surface 1c of the silicon substrate 1, the characteristics of the solar cell element 10 can be improved.

As shown in Fig. 5(a), a second passivation layer 9b containing silicon oxide may be formed between the n-type semiconductor region (second semiconductor layer 3 in this example) and the first passivation layer 9a including an aluminum oxide layer. Accordingly, passivation performance can be improved. The second passivation layer 9b is a layer for reducing defects at the interface between the silicon substrate 1 and the first passivation layer 9a.

### <Method for manufacturing solar cell element>

The steps of the method for manufacturing the solar cell element 10 will now be described in detail.

The silicon substrate 1 is formed by, for example, an existing CZ method, casting method or the like. Hereinafter, an example will be described in which a p-type polycrystalline silicon substrate is used as the silicon substrate 1.

First, an ingot of polycrystalline silicon is prepared by, for example, a casting method. The ingot is then sliced to a thickness of, for example, 250 µm or less to prepare the silicon substrate 1. Thereafter, a surface of the silicon substrate 1 may be very slightly etched with an aqueous solution of NaOH, KOH, hydrofluoric acid, fluonitric acid or the like for cleaning a mechanically damaged layer and a contaminated layer on the cut surface of the silicon substrate 1.

Next, textures (fine irregularity structures) are formed on the first main surface 1a of the silicon substrate 1. As a method for forming textures, a wet etching method using an alkali solution of NaOH or the like, or an acid solution of fluonitric acid or the like, or a dry etching method using a RIE (reactive ion etching) method or the like can be used.

Next, a step of forming the second semiconductor layer 3 as an n-type semiconductor region on the first main surface 1a of the silicon substrate 1 having textures formed in the above-mentioned step is carried out. Specifically, the n-type second semiconductor layer 3 is formed on the outermost layer on the first main surface 1a side of the silicon substrate 1 having textures.

The second semiconductor layer 3 is formed by, for example, a coating thermal diffusion method in which P₂O₅ in the form of paste is applied to a surface of the silicon substrate 1, and thermally diffused, or a gas phase thermal diffusion method using gaseous POCl₃ (phosphorus oxychloride) as a diffusion source. The second semiconductor layer 3 is formed so as to have a depth of about 0.1 to 2 µm, and a sheet resistance value of about 40 to 200 Ω/□. For example, in the gas phase thermal diffusion method, phosphorus glass is formed on a surface of the silicon substrate 1 by heat-treating the silicon substrate 1 for about 5 to 30 minutes at a temperature of about 600 to 800°C in an atmosphere including a diffusion gas comprised of POCl₃ etc. Thereafter, the silicon substrate 1 is heat-treated for about 10 to 40 minutes at a high temperature of about 800 to 900°C in an inert gas such as argon or nitrogen to diffuse phosphorus from the phosphorus glass to the silicon substrate 1, so that the second semiconductor layer 3 is formed on the first main surface 1a side of the silicon substrate 1.

Next, when the second semiconductor layer is also formed on the second main surface 1b side in the step of forming the second semiconductor layer 3, only the second semiconductor layer formed on the second main surface 1b side is etched and removed. Accordingly, a conductivity-type region of p-type is exposed on the second main surface 1b side. For example, only the second main surface 1b side of the silicon substrate 1 is immersed in a fluonitric acid solution to remove the second semiconductor layer formed on the second main surface 1b side. Thereafter, phosphorus glass sticking to the first main surface 1a side of the silicon substrate 1 in formation of the second semiconductor layer 3 is etched and removed.

Thus, the second semiconductor layer formed on the second main surface side 1b is etched and removed with phosphorus glass allowed to remain on the first main surface 1a side. Accordingly, the second semiconductor layer 3 on the first main surface 1a side can be inhibited from being removed or damaged. Here, the second semiconductor layer formed on the side surface 1c of the silicon substrate 1 may also be removed.

In the step of forming the second semiconductor layer 3, a diffusion mask may be formed on the second main surface 1b side, followed by forming the second semiconductor layer 3 by a gas phase thermal diffusion method etc., and subsequently removing the diffusion mask. In this process, a similar structure can be formed. In this case, a step of removing the second semiconductor layer on the second main surface 1b side is not required because the second semiconductor layer is not formed on the second main surface 1b side.

Thus, the silicon substrate 1 can be provided which includes the first semiconductor layer 2 and in which the second semiconductor layer 3 as an n-type semiconductor layer is located on the first main surface 1a side and textures are formed on the surface.

Next, passivation layer 9 comprised of aluminum oxide and the protective layer 11 comprised of silicon oxide are formed on the first main surface 1a of the first semiconductor layer 2 and the second main surface 1b of the second semiconductor layer 3. As a method for forming the passivation layer 9 and the protective layer 11, for example, an ALD method is used. Accordingly, the passivation layer 9 and the protective layer 11 can be formed on the whole periphery including the side surface 1c of the silicon substrate 1.

In formation of the passivation layer 9 and the protective layer 11 by an ALD method, first the silicon substrate 1 provided with the second semiconductor layer 3 is placed in a chamber of a deposition apparatus. The passivation layer 9 comprised of aluminum oxide and the protective layer 11 comprised of silicon oxide are formed by repeatedly carrying out the following steps A to D multiple times with the silicon substrate 1 heated to a temperature in the range of 100°C to 250°C. Accordingly, the passivation layer 9 and the protective layer 11 each having a desired thickness are formed.

The details of the steps A to D are as follows.

[Step A] A silicon raw material such as bisdiethylaminosilane (BDEAS) for forming a silicon oxide layer, or an aluminum raw material such as trimethylaluminum (TMA) for forming aluminum oxide is supplied onto the silicon substrate 1 along with a carrier gas such as an Ar gas or a nitrogen gas. Accordingly, the silicon raw material or aluminum raw material is adsorbed to the whole periphery of the silicon substrate 1. The time during which BDEAS or TMA is supplied may be, for example, about 15 to 3000 milliseconds.

The surface of the silicon substrate 1 may be terminated with OH groups at the start of the step A. In other words, the surface of the silicon substrate 1 may have a structure of Si-O-H. The structure can be formed by, for example, treating the silicon substrate 1 with dilute hydrofluoric acid, and then washing the silicon substrate 1 with pure water.

[Step B] The inside of the chamber of the deposition apparatus is purged with a nitrogen gas to remove the silicon raw material or aluminum raw material in the chamber. Further, in the silicon raw material or aluminum raw material physically and chemically adsorbed to the silicon substrate 1, the silicon raw material or aluminum raw material except for components chemically adsorbed at an atomic layer level is removed. The time during which the inside of the chamber is purged with a nitrogen gas may be, for example, about 1 to several tens of seconds.

[Step C] An oxidizing agent such as water or an ozone gas is supplied into the chamber of the deposition apparatus, so that alkyl groups contained in BDEAS or TMA are removed, and replaced by OH groups. Accordingly, an atomic layer of silicon oxide or aluminum oxide is formed on the silicon substrate 1. The time during which the oxidizing agent is supplied into the chamber may be preferably about 750 to 1100 milliseconds. For example, when hydrogen is supplied into the chamber along with the oxidizing agent, hydrogen atoms are more easily contained in silicon oxide or aluminum oxide.

[Step D] The inside of the chamber of the deposition apparatus is purged with a nitrogen gas to remove the oxidizing agent in the chamber. Here, for example, the oxidizing agent etc. which has not been involved in the reaction during formation of silicon oxide or aluminum oxide at an atomic layer level on the silicon substrate 1 is removed. The time during which the inside of the chamber is purged with a nitrogen gas may be, for example, about 1 to several tens of seconds.

Hereinafter, a series of the steps A to D are repeatedly carried out multiple times to form a silicon oxide layer or aluminum oxide layer having a desired thickness. When a metal oxide layer different from that of silicon oxide is formed as a part of the protective layer 11 in the steps A to D, a metal raw material for the metal oxide layer may be used. For example, when zirconium oxide is formed, TEMAZ (tetrakismethylethylamino zirconium) etc. may be used as a zirconium raw material. For example, when hafnium oxide is formed, TEMAH (tetrakismethylethylamino hafnium) etc. may be used as a hafnium raw material.

When the passivation layer 9 and the protective layer 11 are formed by an ALD method, the passivation layer 9 and the protective layer 11 can be formed in the same chamber without taking out the silicon substrate 1 into the air. Accordingly, a reduction in passivation effect due to formation of defects and ingress of impurities is hard to occur at the interface between both the layers, and productivity is improved.

While deposition of silicon oxide and aluminum oxide using BDEAS as a silicon raw material and TMA as an aluminum raw material has been described here, other raw materials may be used as a silicon raw material and an aluminum raw material. A material which has an appropriate vapor pressure (e.g. 100 Pa or more) as a gas supply source and can be supplied into a chamber in a gaseous state at a raw material supply temperature (for example, a temperature in the range of -20 to 120°C is suitable) may be used. For example, as the silicon raw material, trisdimethylaminosilane (TDMAS), hexamethyldisilazane (HMDSN) or the like can be used. Since such a material contains carbon, nitrogen and so on in the molecule, the formed silicon oxide layer contains carbon, nitrogen and so on. As the aluminum raw material, triethylaluminum (TEA) or the like can be used. The material that can be supplied in a gaseous state may be diluted and supplied with a nitrogen gas, a carbon dioxide gas or the like used as a carrier gas. By adjusting the gas species of a raw material gas and a carrier gas and the mixing ratio thereof, the contents of constituent elements in a film to be formed can be adjusted.

Next, the antireflection layer 5 comprised of a silicon nitride film is formed on the first main surface 1a side of the silicon substrate 1, i.e. on the second semiconductor layer 3. The antireflection layer 5 is formed using, for example, a PECVD method or a sputtering method. When a PECVD method is used, the silicon substrate 1 is heated beforehand at a temperature higher than a temperature during deposition. Thereafter, the antireflection layer 5 is formed on the heated silicon substrate 1 in the following manner: a mixed gas of silane (SiH₄) and ammonia (NH₃) is diluted with nitrogen (N₂), and the diluted gas is formed into plasma by grow discharge decomposition at a reaction pressure of 50 to 200 Pa to deposit a film. The deposition temperature here is set to about 350 to 650°C, and the temperature at which the silicon substrate is heated beforehand is set to a temperature higher by about 50°C than the deposition temperature. As a frequency of a high frequency power source, which is necessary for glow discharge, a frequency of 10 to 500 kHz is used.

While the gas flow rate is appropriately determined according to the size of a reaction chamber, etc., the gas flow rate is, for example, preferably in the range of 150 to 6000 ml/min (sccm), and the flow rate ratio (B/A) of the flow rate A of silane and the flow rate B of ammonia may be 0.5 to 15.

Next, the third semiconductor layer 4 with a one-conductivity-type semiconductor impurity diffused in a high concentration is formed on the second main surface 1b side of the silicon substrate 1. The third semiconductor layer 4 can be formed, for example, at a temperature of about 800 to 1100°C using a thermal diffusion method using boron tribromide (BBr₃) as a diffusion source. The third semiconductor layer 4 can also be formed by a method in which an aluminum paste comprised of an aluminum powder, an organic vehicle and so on is applied, and then heat-treated (fired) at a temperature of about 600 to 850°C to diffuse aluminum to the silicon substrate 1. Use of this method not only allows a desired diffusion region to be formed only on a printed surface, but also makes it unnecessary to remove an opposite-conductivity-type layer of n-type which is formed on the second main surface 1b side in the process of forming the second semiconductor layer 3. Accordingly, an unnecessary pn junction part can be separated only at the outer peripheral portion of the first main surface 1a or the second main surface 1b by laser irradiation etc. after a desired diffusion region is formed.

Next, the first electrode 6, the second electrode 7 and the third electrode 8 are formed in the following manner.

The first electrode 6 is prepared using, for example, a metal paste (first metal paste) which contains a metal powder containing silver as a main component, an organic vehicle, and a glass frit. First, the first metal paste is applied to the first main surface 1a of the silicon substrate 1. Thereafter, the first metal paste is fired under the condition of a maximum temperature of 600 to 850°C and a heating time of about several tens of seconds to several tens of minutes in a firing furnace to form the first electrode 6. As a method for applying the first metal paste, a screen printing method etc. can be used. After the application, the solvent may be evaporated at a predetermined temperature to dry the paste. The first electrode 6 includes the power extraction electrode 6a and the collecting electrode 6b, and by using a screen printing method, the power extraction electrode 6a and the collecting electrode 6b can be formed in one step.

The second electrode 7 is prepared using a metal paste (second metal paste) which contains a metal powder containing silver as a main component, an organic vehicle, a glass frit and so on. As a method for applying the second metal paste to the silicon substrate 1, for example, a screen printing method etc. can be used. After the application, the solvent may be evaporated at a predetermined temperature to dry the paste. Thereafter, the second metal paste is fired under the condition of a maximum temperature of 600 to 850°C and a heating time of about several tens of seconds to several tens of minutes in a firing furnace to form the second electrode 7 on the second main surface 1b side of the silicon substrate 1.

The third electrode 8 is prepared using a metal paste (third metal paste) which contains a metal powder containing aluminum as a main component, an organic vehicle, and a glass frit. The third metal paste is applied onto the second main surface 1b of the silicon substrate 1 so as to come into contact with a part of the second metal paste applied beforehand. Here, the third metal paste may be applied to almost the whole of the second main surface 1b except for a part of an area where the second electrode 7 is formed. As a method for applying the third metal paste, a screen printing method etc. can be used. After the application, the solvent may be evaporated at a predetermined temperature to dry the paste. The third metal paste is fired under the condition of a maximum temperature of 600 to 850°C and a heating time of about several tens of seconds to several tens of minutes in a firing furnace to form the third electrode 8 on the second main surface 1b side of the silicon substrate 1. The third semiconductor layer 4 and the third electrode 8 may be simultaneously formed using the third metal paste.

For forming the second electrode and the third electrode while leaving the passivation layer 9 and the protective layer 11 formed on the second main surface 1b side of the silicon substrate 1, first the third metal paste is directly applied to a predetermined region on the passivation layer 9 and the protective layer 11. Thereafter, a fire-through method may be used to perform a high-temperature heat treatment with a maximum temperature of 600 to 850°C. In the fire-through method, the applied third metal paste component breaks through the passivation layer 9 and the protective layer 11, so that the third semiconductor layer 4 is formed on the second main surface 1b side of the silicon substrate 1, and the third electrode 8 is formed on the third semiconductor layer 4.

The solar cell element 10 can be prepared through the above-mentioned steps.

The third electrode 8 may be formed after the second electrode 7 is formed. The second electrode 7 is not required to be in direct contact with the silicon substrate 1, and the passivation layer 9 may exist between the second electrode 7 and the silicon substrate 1.

The first electrode 6, the second electrode 7 and the third electrode 8 may be formed by applying and then simultaneously firing the respective metal pastes. Accordingly, productivity is improved, and the thermal history of the silicon substrate 1 can be reduced to improve the power characteristics of the solar cell element 10.

### <<Second Example>>

A second example will now be described in which the present invention is applied to a PERC (passivated emitter rear cell) type solar cell element. Descriptions of the same parts as in the first embodiment are omitted.

### <Solar cell element>

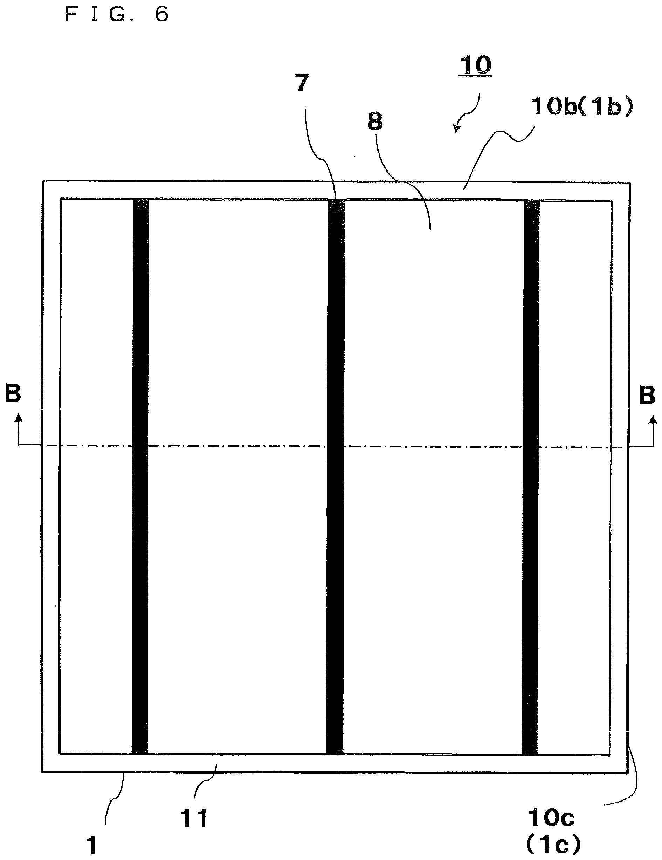

As shown in Fig. 6 and Fig. 7, a solar cell element 10 includes a third electrode 8 formed on a protective layer 11. Further, the third electrode 8 is formed on a passivation layer 9, and on a second main surface 1b of a silicon substrate 1, which is not provided with the protective layer 11. Thus, the third electrode 8 is formed so as to cover substantially the whole of the second main surface 1b of the silicon substrate 1.

In this example, the third electrode 8 is formed on the protective layer 11, but permeation of moisture from the outside can be suppressed to prevent impairment of the passivation effect. Accordingly, reliability can be improved without impairing the photoelectric conversion efficiency of the solar cell element 10. Since the third electrode 8 is formed so as to cover substantially the whole of the second main surface 1b of the silicon substrate 1, collected carriers can efficiently move to the second electrode 7. Accordingly, the initial photoelectric conversion efficiency of the solar cell element 10 can be improved.

As other passivation layer, silicon nitride formed by the PECVD method may be located on the first passivation layer 9 comprised of aluminum oxide, and the protective layer 11. Formation of silicon nitride ensures that the passivation layer 9 is hard to be subjected to fire-through at the time of firing a third metal paste. Plasma damage to the passivation layer 9 is reduced due to formation of the protective layer 11 comprised of silicon oxide formed by an ALD method.

### <Method for manufacturing solar cell element>

By the same method as in the first example, the passivation layer 9 is formed on the second main surface 1b of the silicon substrate 1 including the second semiconductor layer 3, and the protective layer 11 is formed on the passivation layer 9.

Next, the passivation layer 9 and the protective layer 11 are partially removed to form a contact hole for obtaining electrical connection between the silicon substrate 1 and the third electrode 8. For example, the contact hole may be formed by laser beam irradiation, or formed by etching etc.

Next, the third metal paste containing a glass frit and an aluminum powder is applied to a predetermined region on the contact hole and the protective layer 11. Thereafter, the third metal paste is fired under the condition of a maximum temperature of 600 to 800°C and a heating time of several tens of seconds to several tens of minutes to form the third electrode 8. Here, the passivation layer 9 and the protective layer 11 may be prevented from being subjected to fire-through at the time of firing the third metal paste. In this case, for example, it is practical to lower the firing temperature, shorten the firing time, or use lead-free glass as a composition of the glass frit.

When the thickness of the protective layer 11 is 3 to 15 nm, initial photoelectric conversion efficiency can be maintained. Use of the protective layer 11 can ensure that the passivation layer 9 is hard to be subjected to fire-through with the third metal paste at the time of forming the third electrode 8. Further, a reduction in initial photoelectric conversion efficiency due to a reduction in passivation effect is made hard to occur, so that the solar cell element 10 having high reliability can be provided.

### <Solar cell module>

A solar cell module 20 includes one or more solar cell element 10. For example, it is sufficient that the solar cell module 20 includes a plurality of solar cell elements 10 which are mutually electrically connected. The solar cell module 20 is formed by connecting a plurality of solar cell elements 10, for example, in series or in parallel when the electric power of the single solar cell element 10 is low. A plurality of solar cell modules 20 are combined, so that a practical electric power is extracted. Hereinafter, one example will be described in which the solar cell module 20 includes a plurality of solar cell elements 10.

As shown in Fig. 8 and Fig. 9, the solar cell module 20 includes, for example, a laminate in which a transparent member 23, a front filler 24, a plurality of solar cell elements 10, a wiring conductor 21, a back filler 25 and a back surface protective material 26 are laminated. Here, the transparent member 23 is a member for protecting a light-receiving surface which receives sunlight in the solar cell module 20. The transparent member 23 may be, for example, a transparent flat member. As a material of the transparent member 23, for example, glass or the like is employed. Each of the front filler 24 and the back filler 25 may be, for example, a transparent filler. As a material of each of the front filler 24 and the back filler 25, for example, an ethylene-vinyl acetate copolymer (EVA) or the like is employed. The back surface protective material 26 is a member for protecting the back surface of the solar cell module 20. As a material of the back surface protective material 26, for example, polyethylene terephthalate (PET) or polyvinyl fluoride resin (PVF) is employed. The back surface protective material 26 may have a single-layer structure, or a laminated structure.

The wiring conductor 21 is a member (connection member) which electrically connects a plurality of solar cell elements 10. Among a plurality of solar cell elements 10 included in the solar cell module 20, solar cell elements 10 that are adjacent to each other in one direction are electrically connected. A power extraction electrode 6a of one solar cell element 10 and the second electrode 7 of the other solar cell element 10 are connected by the wiring conductor 21. Here, the thickness of the wiring conductor 21 may be, for example, 0.1 to 0.2 mm. The width of the wiring conductor 21 may be, for example, about 2 mm. As the wiring conductor 21, for example, a member obtained by covering the whole surface of a copper foil with solder is used.

One end of the electrode of the first solar cell element 10 and one end of the last solar cell element 10 among a plurality of solar cell elements 10 that are electrically connected in series are each electrically connected to a terminal box 28 as a power extraction section by power extraction wiring 22. As shown in Fig. 8, the solar cell module 20 may include a frame body 27 which holds the laminate at the periphery thereof (not illustrated in Fig. 9). As a material of the frame body 27, for example, an aluminum alloy having corrosion resistance and strength is employed.

In this way, the solar cell module 20 is prepared using the solar cell element 10 including the protective layer 11. Accordingly, the passivation layer 9 can be protected by the protective layer 11 from moisture permeating into the solar cell module 20. As a result, degradation of the passivation layer 9 can be reduced, so that the reliability of the solar cell module 20 can be improved.

When EVA is employed as a material of the back filler 25, permeation of humid air, moisture or the like at a high temperature may cause hydrolysis with time to generate acetic acid because EVA includes vinyl acetate. On the other hand, in this example, negative influences of generated acetic acid on the passivation layer 9 etc. can be reduced because the protective layer 11 is provided on the passivation layer 9. As a result, the long-term reliability of the solar cell module 20 is improved.

When EVA is employed as a material of at least one of the front filler 24 and the back filler 25, the EVA may contain an acid acceptor including magnesium hydroxide, calcium hydroxide or the like. Accordingly, acetic acid generated from EVA can be neutralized, and therefore the durability of the solar cell module 20 is improved, so that negative influences of acetic acid on the passivation layer 9 etc. can be reduced. As a result, the reliability of the solar cell module 20 is secured over a long period of time.

### <Method for manufacturing solar cell module>

A specific method for manufacturing the solar cell module 20 will be described in detail with reference to Fig. 8 and Fig. 9. First, a plurality of solar cell elements 10 are disposed in series and in parallel, and solar cell elements 10 adjacent to each other are electrically connected by the wiring conductor 21. For example, as a method for connecting the wiring conductor 21 using solder, soldering iron, hot air, laser, pulse heat or the like can be used. By this method, the wiring conductor 21 is soldered to the power extraction electrode 6a and the second electrode 7.

Next, the front filler 24 is placed on the transparent member 23, and further, a plurality of solar cell elements 10, to which the wiring conductor 21 and the power extraction wiring 22 are connected, are placed on the front filler 24. Further, the back filler 25 and the back surface protective material 26 are sequentially placed on the solar cell elements 10. Thereafter, the power extraction wiring 22 is led to the outside of the back surface protective material 26 through a slit provided in each member on the back surface side. The laminate in this state is set in a laminator, and heated at about 80 to 200°C for, for example, 15 to 60 minutes while being compressed under a reduced pressure. Accordingly, a solar cell module integrated with a laminate can be obtained.

Next, the terminal box 28 is attached. Specifically, using a silicone-based adhesive etc., the terminal box 28 is attached on the back surface protective material 26 to which the power extraction wiring 22 is led. The power extraction wiring 22 on the positive side and on the negative side is fixed to terminals (not illustrated) of the terminal box 28 by soldering or the like. Thereafter, a lid is attached to the terminal box 28.

Finally, the frame body 27 formed of an aluminum alloy etc. is attached to the outer peripheral portion of the main body to complete the solar cell module 20. The frame body 27 can be attached by, for example, fixing its corner portions to the outer peripheral portion of the main body using screws etc. In this way, the solar cell module 20 is completed.

The silicon substrate 1 may be washed before the passivation layer 9 is formed. As a washing process, for example, a washing method including a hydrofluoric acid treatment, RCA washing (a washing method developed by RCA in U.S.; washing is performed using high-temperature/high-concentration sulfuric acid/hydrogen peroxide water, dilute hydrofluoric acid (room temperature), aqueous ammonia, hydrochloric acid/hydrogen peroxide water or the like) and a hydrofluoric acid treatment after the washing, or a washing method including SPM (sulfuric acid/hydrogen peroxide/water mixture) washing, a hydrofluoric acid treatment after the washing and so on can be used.

In any step after the step of forming the passivation layer 9, the recombination rate in the silicon substrate 1 can be further reduced by performing an annealing treatment using a gas containing hydrogen.

The solar cell element 10 may be a solar cell element having a metal wrap through structure with a part of the first electrode 6 provided on the second main surface 10b side, or a back contact-type solar cell element having an IBC (interdigitated back contact) structure. The solar cell element 10 may be a double-side light-receiving solar cell element in which light can be made incident from both the first main surface 10a and the second main surface 10b.

As a semiconductor substrate, one obtained by providing the silicon substrate 1 mainly including an n-type semiconductor region, and forming a p-type semiconductor region on one main surface of the substrate may be used. Here, the solar cell element 10 including on a p-type semiconductor region the passivation layer 9 comprised of aluminum oxide and the protective layer 11 comprised of a silicon oxide layer can be obtained, and the effects of the above-described embodiment can be expected.

After formation of the protective layer 11, the passivation layer 9 on the first main surface 1a side of the silicon substrate 1 may be etched and removed, followed by forming the antireflection layer 5 comprised of silicon nitride. Accordingly, a silicon nitride layer having a positive fixed charge is formed on the second semiconductor layer 3 as an n-type semiconductor layer, and therefore initial photoelectric conversion efficiency can be improved by the passivation effect of the silicon nitride layer. The antireflection layer 5 comprised of a silicon nitride layer may be formed on the first main surface 1a side of the silicon substrate 1 before the first passivation layer 9a is formed.

A laser beam may be applied in the step of partially removing the passivation layer 9 and the protective layer 1 1 to form a contact hole. Here, residues of the passivation layer 9 and the protective layer 11 after application of the laser beam are removed using low-concentration hydrofluoric acid etc. after formation of the contact hole. Accordingly, the contact resistance between the first main surface 1a of the silicon substrate 1 and the third electrode 8 can be reduced.

When the third electrode 8 is formed, the following steps may be employed: applying a third metal paste which is subjected to fire-through to form the third semiconductor layer 4; and applying a fourth metal paste, which contains a lead-free glass frit and is hard to be subjected to fire-through, onto each of the protective layer 11 and the third metal paste which is subjected to fire-through to form the third semiconductor layer 4. In the step of firing the third metal paste and the fourth metal paste, the firing temperature for the fourth metal paste may be lowered to ensure that the passivation layer 9 and the protective layer 11 are hard to be subjected to fire-through.

### Examples

Hereinafter, examples will be described.

First, a polycrystalline silicon substrate having a square shape of about 156 mm on each side in plan view and having a thickness of about 200 µm was provided as a silicon substrate 1 including a p-type first semiconductor layer 2. The silicon substrate 1 was etched with a NaOH aqueous solution to remove a damaged layer on a surface thereof. Thereafter, the silicon substrate 1 was washed. Textures were formed on the first main surface 1a side of the silicon substrate 1 using a RIE method.

Next, phosphorus was diffused over the silicon substrate 1 by a gas phase thermal diffusion method using phosphorus oxychloride (POCl₃) as a diffusion source. Accordingly, an n-type second semiconductor region 3 having a sheet resistance of about 90 Ω/□ was formed. The second semiconductor layer 3 was also formed on a side surface 1c and the first main surface 1a side of the silicon substrate 1, but the second semiconductor layer 3 was removed with a fluonitric acid solution. Thereafter, glass remaining on the silicon substrate 1 was removed with a hydrofluoric acid solution.

Next, in solar cell elements 10 used in Examples 1 to 16, first an aluminum oxide layer as a first passivation layer 9a was formed on the whole surface of the silicon substrate 1 using an ALD method.

Next, in the solar cell elements 10 used in Examples 1 to 14, a silicon oxide layer was formed as a protective layer 11 using an ALD method. In the solar cell element 10 used in Example 15, a protective layer 11 having a laminated structure of a silicon oxide layer and a zirconium oxide layer was formed as the protective layer 11 using an ALD method. In Example 16, a protective layer 11 having a laminated structure of a silicon oxide layer and a hafnium oxide layer was formed as the protective layer 11 using an ALD method.

The ALD method was carried out in the following manner. The silicon substrate 1 was placed in a chamber of a deposition apparatus, and maintained in such a manner that the surface temperature of the silicon substrate 1 was about 100 to 200°C. TMA was used as an aluminum raw material. BDEAS or TDMAS was used as a silicon raw material. TEMAZ was used as a zirconium raw material. TEMAH was used as a hafnium raw material. An O₃ gas was used as an oxidizing agent.

The above-mentioned steps A to D were repeatedly carried out multiple times to form a first passivation layer 9a having a thickness of about 30 nm and comprised of aluminum oxide (Comparative Examples 1 and 2 and Examples 1 to 16). Similarly, the steps A to D were repeatedly carried out multiple times to form a protective layer 11 having a thickness of 5 to 20 nm and having a single-layer structure of silicon oxide (Examples 1 to 16). In Example 1 and Examples 3 to 6, a CO₂ gas was used as a carrier gas during deposition of the protective layer 11 to increase the concentration of carbon in silicon oxide. In the same manner as described above, a protective layer 11 having a laminated structure of a silicon oxide layer having a thickness of 5 nm and a zirconium oxide layer having a thickness of 2 nm was formed (Example 15). Further, in the same manner as described above, a protective layer 11 having a laminated structure of a silicon oxide layer having a thickness of 5 nm and a hafnium oxide layer having a thickness of 2 nm was formed (Example 16).

In Examples 12 to 14, a second passivation layer 9b comprised of silicon oxide and having a thickness of 0.3 to 1 nm was formed on the silicon substrate 1 by an ALD method before formation of the first passivation layer 9a comprised of aluminum oxide, and other manufacturing conditions were the same as in Example 2.

In Comparative Example 1, the protective layer 11 was not formed. Further, in Comparative Example 2, the protective layer 11 comprised of silicon oxide was formed by a PECVD method.

Thereafter, an antireflection layer 5 comprised of a silicon nitride film was formed on the protective layer 11 on the first main surface 1a side by a PECVD method. On the first main surface 1a side, a silver paste was applied in a pattern of a first electrode 6, and on the second main surface 1b side, a silver paste was applied in a pattern of a second electrode 7. On the second main surface 1b side, an aluminum paste was applied in a pattern of a third electrode 8. By firing these conductive pastes, the third semiconductor region 4, the first electrode 6, the second electrode 7 and the third electrode 8 were formed to prepare the solar cell element 10.

Conditions for formation of the solar cell elements used in Comparative Examples 1 and 2 and Examples 1 to 16 are shown in Table 1.

**[Table 1]**

| | Protective layer (thickness (nm)) | Method for formation of protective layer | Silicon raw material | Concentration of H (atom%) | Concentration of C (atom%) | Concentration of N (atom%) | Presence/absence of second passivation layer (thickness (nm)) | Initial maximum power Pm (normalized value) | Reliability test Power decrease ratio (%) | |
|---|---|---|---|---|---|---|---|---|---|---|
| | | | | | | | | | After 150 hours | After 400 hours |
| Comparative Example 1 | None | - | - | - | - | - | Absent | 100 | 2.30 | 3.10 |
| Comparative Example 2 | Silicon oxide(10) | PECVD | Silane | 15 | Not detected | Not detected | Absent | 98 | 0.96 | 1.97 |
| Example 1 | Silicon oxide(10) | ALD | TDMAS | 5 | 5.6 | 0.5 | Absent | 100 | 0.14 | 0.52 |
| Example 2 | Silicon oxide(10) | ALD | BDEAS | 10 | 1.2 | 0.1 | Absent | 100 | 0.16 | 0.62 |
| Example 3 | Silicon oxide(10) | ALD | BDEAS | 10 | 5.7 | 0.1 | Absent | 100 | 0.16 | 0.53 |
| Example 4 | Silicon oxide(10) | ALD | BDEAS | 10 | 9.6 | 0.1 | Absent | 100 | 0.14 | 0.50 |
| Example 5 | Silicon oxide(10) | ALD | BDEAS | 8 | 5.3 | 0.1 | Absent | 100 | 0.15 | 0.54 |
| Example 6 | Silicon oxide(10) | ALD | BDEAS | 3 | 9.8 | 0.1 | Absent | 100 | 0.14 | 0.51 |
| Example 7 | Silicon oxide(3) | ALD | BDEAS | 10 | 1.2 | 0.1 | Absent | 100 | 0.42 | 1.10 |
| Example 8 | Silicon oxide(5) | ALD | BDEAS | 10 | 1.2 | 0.1 | Absent | 100 | 0.35 | 0.93 |
| Example 9 | Silicon oxide(7) | ALD | BDEAS | 10 | 1.2 | 0.1 | Absent | 100 | 0.27 | 0.77 |
| Example 10 | Silicon oxide(15) | ALD | BDEAS | 10 | 1.2 | 0.1 | Absent | 100 | 0.16 | 0.54 |
| Example 11 | Silicon oxide(20) | ALD | BDEAS | 10 | 1.2 | 0.1 | Absent | 99 | 0.14 | 0.55 |
| Example 12 | Silicon oxide(10) | ALD | BDEAS | 10 | 1.2 | 0.1 | Present (0.3) | 101 | 0.18 | 0.61 |
| Example 13 | Silicon oxide(10) | ALD | BDEAS | 10 | 1.2 | 0.1 | Present (0.5) | 101 | 0.19 | 0.61 |
| Example 14 | Silicon oxide(10) | ALD | BDEAS | 10 | 1.2 | 0.1 | Present (1.0) | 101 | 0.17 | 0.63 |
| Example 15 | Silicon oxide (5) Zirconium oxide(2) | ALD | BDEAS TEMAZ | 10 | 1.2 | 0.1 | Absent | 100 | 0.21 | 0.68 |
| Example 16 | Silicon oxide (5) Hafnium oxide (2) | ALD | BDEAS TEMAH | 10 | 1.2 | 0.1 | Absent | 100 | 0.23 | 0.67 |

The concentrations of carbon, hydrogen, nitrogen and so on contained in the protective layer 11 of the solar cell element 10 used in each of Examples and Comparative Example 2 were measured by a SIMS method. "Not detected" in Comparative Example 2 means that a concentration of less than 0.01 atom% was not detected. The thickness of the protective layer 11 etc. was measured by a spectroscopic ellipsometer or TEM (transmission electron microscope).

A solar cell module 20 as shown in Fig. 8 was prepared, and the following reliability test was conducted for Examples and Comparative Examples 1 and 2.

In the reliability test, the solar cell module 20 in each of Examples and Comparative Examples 1 and 2 was put in a thermo-hygrostat testing machine at a temperature of 125°C and a humidity of 95%, and the power decrease ratio with respect to the initial maximum power (hereinafter, referred to as Pm) was measured after 150 hours and after 400 hours. The Pm of the solar cell module was measured under the condition of 100 mW/cm² and an AM (air mass) of 1.5 based on JIS C 8913. The measurement results thereof are also shown in Table 1. For the value of Pm shown in Table 1, the measurement results in Comparative Example 2 and Examples 1 to 16 are normalized with respect to the measurement result in Comparative Example 1 where the measurement result in Comparative Example 1 is set to 100.

As shown in Table 1, Pm in Comparative Example 2 was slightly lower than Pm in Comparative Example 1. In Comparative Example 1 and Comparative Example 2, the power decrease ratio in the reliability test was higher as compared to Examples 1 to 16.

It seems that the decrease in Pm in Comparative Example 2 was ascribable to degradation of the passivation layer 9 by plasma in preparation of the protective layer 11 by a PECVD method. It appears that the result of the power decrease ratio of the solar cell module 20 in the reliability test in Comparative Example 2 was ascribable to the following factor. The protective layer 11 formed by a PECVD method had an uneven thickness, and therefore permeation of moisture in a region where the protective layer 11 had a small thickness was promoted, so that the passivation layer 9 was selectively degraded.

It was confirmed that Pm in each of Examples 1 to 10 and Examples 12 to 16 (using a solar cell element in which the protective layer 11 of silicon oxide deposited by an ALD method has a thickness of 3 to 15 nm) was equal to or higher than Pm in Comparative Example 1. Pm in Example 11 was slightly lower than Pm in Comparative Example 1 because in Example 11, the thickness of the protective layer 11 of silicon oxide having a fixed charge opposite to that of aluminum oxide was 20 nm, but it was confirmed that Pm in Example 11 was higher than Pm in Comparative Example 2.

In Comparative Example 1 using a solar cell element which does not include the protective layer 11, the power decreased by 3.1% after elapse of 400 hours. On the other hand, it was confirmed that in the solar cell modules 20 of Examples 1 to 16 which include the protective layer 11, the power decrease ratio was 1.1% or less even after elapse of 400 hours, and thus Pm was maintained over a long period of time.

It was confirmed that in Example 1, Examples 3 to 6 and Example 10, the power decrease ratio of the solar cell module in the reliability test was particularly low. It seems that the result of the power decrease ratio in Example 1 and Examples 3 to 6 was ascribable to a decrease in moisture permeability due to an increase in concentration of carbon in the protective layer 11. It seems that the result of the power decrease ratio in Example 1 was ascribable to a decrease in moisture permeability due to existence of nitrogen when compared to the result in Example 5. It appears that the result of the power decrease ratio in Example 10 was ascribable to formation of silicon oxide with a large thickness, leading to a decrease in moisture permeability despite the low concentration of carbon.

It has been found that in Examples 15 and 16, the thickness of the overall protective layer 11 can be reduced, and the power decrease ratio of the solar cell module 20 can be made lower as compared to Example 7 in which the protective layer 11 has the same thickness.

It has been found that when nitrogen exists in the protective layer 11 in an amount of about 0.1 to 0.5 atom%, the amount of moisture arriving at the passivation layer 9 can be reduced as in the case where the protective layer 11 contains carbon (not shown in Table 1).

In Examples 12 to 14 where the second passivation layer 9b having a thickness of 0.3 to 1 nm and comprised of silicon oxide was formed, Pm of the solar cell module 20 was improved. This may be because defects at the interface between the silicon substrate 1 and the first passivation layer 9a were reduced.

### Reference Signs List

- 1:: Silicon substrate
- 1a:: First main surface
- 1b:: Second main surface
- 1c:: Side surface
- 2:: First semiconductor layer (p-type semiconductor region)
- 3:: Second semiconductor layer (n-type semiconductor region)
- 4:: Third semiconductor layer
- 5:: Antireflection layer
- 6:: First electrode
- 6a:: Power extraction electrode
- 6b:: Collecting electrode
- 7:: Second electrode
- 8:: Third electrode
- 9:: Passivation layer
- 9a:: First passivation layer
- 9b:: Second passivation layer
- 10:: Solar cell element
- 10a:: First main surface
- 10b:: Second main surface
- 10c:: Side surface
- 11:: Protective layer
- 20:: Solar cell module
- 21:: Wiring conductor
- 22:: Power extraction wiring
- 23:: Transparent member
- 24:: Front filler
- 25:: Back filler
- 26:: Back protective material
- 27:: Frame body
- 28:: Terminal box

## Claims

1. A solar cell element comprising:
a silicon semiconductor substrate (1) including a p-type semiconductor region (2) on one main surface (1a; 1b) thereof;
a first passivation layer (9a), containing aluminium oxide, located on the p-type semiconductor region (2);
a second passivation layer (9b), including a silicon oxide layer, located between the p-type semiconductor region (2) and the first passivation layer (9a) ; and
a protective layer (11), containing silicon oxide which contains hydrogen and carbon, located on the first passivation layer (9a) ; wherein
a thickness of the second passivation layer (9b) is smaller than a thickness of the protective layer (11), and the total thickness of the second passivation layer (9b) and the protective layer (11) is smaller than the thickness of the first passivation layer (9a).

2. The solar cell element according to claim 1, further comprising an electrode located on a side opposite to the first passivation layer of the protective layer.

3. The solar cell element according to claim 1 or 2, wherein the protective layer (11) further contains nitrogen.

4. The solar cell element according to any one of Claims 1 to 3, wherein the protective layer (11) has a hydrogen concentration of 1 to 10 atom%, and a carbon concentration of 1 to 10 atom%.

5. The solar cell element according to any one of Claims 1 to 4, wherein the thickness of the protective layer (11) is 3 to 15 nm.

6. The solar cell element according to any one of Claims 1 to 5, wherein the protective layer (11) has a structure in which the silicon oxide layer and one or more metal oxide layer containing at least one of zirconium and hafnium are laminated.

7. The solar cell element according to any one of Claims 1 to 6, wherein an n-type semiconductor region (3) is located on the other main surface situated on a side opposite to the one main surface (1a; 1b) of the semiconductor substrate (1), and a silicon nitride layer is located on the n-type semiconductor region (3).

8. A solar cell module (20) comprising the solar cell element according to any one of Claims 1 to 7.

## Patentansprüche

1. Solarzellenelement mit:
einem Silizium-Halbleitersubstrat (1), das einen p-Typ-Halbleiterbereich (2) auf einer seiner Hauptoberflächen (1a; 1b) umfasst;
einer ersten Passivierungsschicht (9a), die sich auf dem p-Typ-Halbleiterbereich (2) befindet und Aluminiumoxid enthält;
einer zweiten Passivierungsschicht (9b), die sich zwischen dem p-Typ-Halbleiterbereich (2) und der ersten Passivierungsschicht (9a) befindet und Siliziumoxid enthält; und
einer Schutzschicht (11), die sich auf der ersten Passivierungsschicht (9a) befindet und Siliziumoxid enthält, das Wasserstoff und Kohlenstoff enthält, wobei
eine Dicke der zweiten Passivierungsschicht (9b) kleiner ist als eine Dicke der Schutzschicht (11), und die Gesamtdicke der zweiten Passivierungsschicht (9b) und der Schutzschicht (11) kleiner ist als die Dicke der ersten Passivierungsschicht (9a).

2. Solarzellenelement nach Anspruch 1, das ferner eine Elektrode umfasst, die an einer Seite gegenüberliegend der ersten Passivierungsschicht der Schutzschicht angeordnet ist.

3. Solarzellenelement nach Anspruch 1 oder 2, wobei die Schutzschicht (11) ferner Stickstoff enthält.

4. Solarzellenelement nach einem der Ansprüche 1 bis 3, wobei die Schutzschicht (11) eine Wasserstoffkonzentration von 1 bis 10 Atom-% und eine Kohlenstoffkonzentration von 1 bis 10 Atom-% aufweist.

5. Solarzellenelement nach einem der Ansprüche 1 bis 4, wobei die Dicke der Schutzschicht (11) 3 bis 15 nm beträgt.

6. Solarzellenelement nach einem der Ansprüche 1 bis 5, wobei die Schutzschicht (11) eine Struktur aufweist, in der eine Siliziumoxidschicht und eine oder mehrere Metalloxidschichten, die Zirkonium und/oder Hafnium enthalten, laminiert sind.

7. Solarzellenelement nach einem der Ansprüche 1 bis 6, wobei sich ein n-Typ-Halbleiterbereich (3) auf der anderen Hauptoberfläche befindet, die sich auf einer Seite gegenüber der einen Hauptoberfläche (1a; 1b) des Halbleitersubstrats befindet (1), und eine Siliziumnitridschicht auf dem n-Halbleiterbereich (3) angeordnet ist.

8. Solarzellenmodul (20), welches das Solarzellenelement nach einem der Ansprüche 1 bis 7 umfasst.

## Revendications

1. Élément de cellule solaire, comprenant :
un substrat semi-conducteur en silicium (1) incluant une région de semi-conducteur de type p (2) sur une surface principale (1a ; 1b) de celui-ci ;
une première couche de passivation (9a), contenant de l'oxyde d'aluminium, située sur la région de semi-conducteur de type p (2) ;
une seconde couche de passivation (9b), incluant une couche d'oxyde de silicium, située entre la région de semi-conducteur de type p (2) et la première couche de passivation (9a) ; et
une couche de protection (11), contenant de l'oxyde de silicium qui contient de l'hydrogène et du carbone, située sur la première couche de passivation (9a) ; dans lequel
une épaisseur de la seconde couche de passivation (9b) est plus petite qu'une épaisseur de la couche de protection (11), et l'épaisseur totale de la seconde couche de passivation (9b) et de la couche de protection (11) est plus petite que l'épaisseur de la première couche de passivation (9a).

2. Élément de cellule solaire selon la revendication 1, comprenant en outre une électrode située sur un côté opposé à la première couche de passivation de la couche de protection.

3. Élément de cellule solaire selon la revendication 1 ou 2, dans lequel la couche de protection (11) contient en outre de l'azote.

4. Élément de cellule solaire selon l'une quelconque des revendications 1 à 3, dans lequel la couche de protection (11) a une concentration en hydrogène de 1 à 10 % atomique, et une concentration en carbone de 1 à 10 % atomique.

5. Élément de cellule solaire selon l'une quelconque des revendications 1 à 4, dans lequel l'épaisseur de la couche de protection (11) est de 3 à 15 nm.

6. Élément de cellule solaire selon l'une quelconque des revendications 1 à 5, dans lequel la couche de protection (11) a une structure dans laquelle la couche d'oxyde de silicium et une ou plusieurs couche d'oxyde de métal contenant au moins un de zirconium et de hafnium sont stratifiées.

7. Élément de cellule solaire selon l'une quelconque des revendications 1 à 6, dans lequel une région de semi-conducteur de type n (3) est située sur l'autre surface principale située sur un côté opposé à l'une surface principale (la ; 1b) du substrat semi-conducteur (1), et une couche de nitrure de silicium est située sur la région de semi-conducteur de type n (3).

8. Module de cellule solaire (20), comprenant l'élément de cellule solaire selon l'une quelconque des revendications 1 à 7.
